# EUROPEAN PATENT SPECIFICATION

(11) **EP 4 618 144 B1**
(45) Date of publication and mention of the grant of the patent: **10.06.2026**
(21) Application number: 25161798.1
(22) Date of filing: 05.03.2025
(51) Int. Cl.: H10W 40/73, F28D 15/02, F28D 15/04, B23P 15/26

(54) **THREE DIMENSIONAL HEAT DISSIPATION DEVICE, MANUFACTURING METHOD THEREOF, AND SHAPING TOOL**
DREIDIMENSIONALE WÄRMEABLEITUNGSVORRICHTUNG, HERSTELLUNGSVERFAHREN DAFÜR UND FORMWERKZEUG
DISPOSITIF DE DISSIPATION DE CHALEUR TRIDIMENSIONNEL, SON PROCÉDÉ DE FABRICATION ET OUTIL DE FAÇONNAGE

(30) Priority: 14.03.2024 CN 202410295719
(43) Date of publication of application: 17.09.2025
(73) Proprietor: Purple Cloud Development Pte. Ltd., Singapore 128424 (SG)
(72) Inventor: WANG, Xue Mei, Hui Zhou City (CN)
(74) Representative: Grünecker Patent- und Rechtsanwälte PartG mbB

(56) References cited:
- CN-A- 116 263 309
- US-A1- 2017 314 873
- US-B2- 10 663 231
- US-B2- 7 619 888

## Description

### TECHNICAL FIELD

The present disclosure relates to the technical field of heat sinks, and in particular relates to a manufacturing method and shaping mold for a three-dimensional heat dissipation device. US 2017/314873 discloses a manufacturing method with the features of the preamble of claim 1.

### BACKGROUND OF THE DISCLOSURE

Most existing three-dimensional heat dissipation devices are each composed of a thermally conductive casing and a heat pipe. The heat pipe has a round or flat shape. However, when manufacturing a three-dimensional heat dissipation device with a flat heat pipe, all current processing methods are to first shape the round heat pipe into a flat heat pipe and then install the flat heat pipe on the thermally conductive casing. In an actual processing process, it is found that the existing processing methods have at least the following drawbacks:
1. Due to the special structure of the flat heat pipe, it is easier to cause shape deformation than the round heat pipe during automated installation. Therefore, only manual pipe installation can be used, resulting in low production efficiency. Even if automated pipe installation is used reluctantly, the relative stability of product quality will be relatively poor.
2. In the previous processing methods, when the flat heat pipe is installed and then subjected to an aging test, the aging test temperature is lower than that of the round heat pipe while increasing the aging time, thereby reducing the product production capacity.
3. In the previous processing methods, when the flat heat pipe is installed and then subjected to a helium inspection test, the helium pressure it withstands is lower than that of the round heat pipe. If the helium pressure is increased reluctantly, the flat heat pipe will be deformed, making the relative stability of product quality relatively poor.

Therefore, improving the relative stability of product quality while increasing the production capacity of the three-dimensional heat dissipation device with the flat heat pipe is one of the drawbacks that the research and development personnel should solve.

### SUMMARY OF THE DISCLOSURE

The invention is as as defined in the appended claims. Exemplary embodiments of the present disclosure provide a manufacturing method and shaping mold for a three-dimensional heat dissipation device, which may but is not required to improve the relative stability of product quality while improving the production capacity of a three-dimensional heat dissipation device with a flat heat pipe.

An example embodiment of the present disclosure provides a manufacturing method for a three-dimensional heat dissipation device, comprising: a thermally conductive casing manufacturing step: manufacturing a thermally conductive casing with an airtight chamber; a preliminary three-dimensional heat dissipation device manufacturing step: installing at least one round heat pipe on the thermally conductive casing to form a preliminary three-dimensional heat dissipation device; and a final three-dimensional heat dissipation device manufacturing step: fixing the preliminary three-dimensional heat dissipation device by means of a shaping mold, and shaping a pipe body of the round heat pipe into a flat heat pipe to obtain a final three-dimensional heat dissipation device.

Another example embodiment of the present disclosure provides a shaping mold, wherein the shaping mold can be used in the above manufacturing method to shape a preliminary three-dimensional heat dissipation device, the preliminary three-dimensional heat dissipation device comprises a thermally conductive casing and a round heat pipe installed on the thermally conductive casing, the preliminary three-dimensional heat dissipation device can be fixed by means of the shaping mold, and a pipe body of the round heat pipe of the preliminary three-dimensional heat dissipation device can be shaped into a flat heat pipe to obtain a final three-dimensional heat dissipation device.

According to exemplary implementations of example disclosed embodiments, in a manufacturing method and shaping mold for the three-dimensional heat dissipation device of for example the above example embodiments, when manufacturing three-dimensional heat dissipation devices with flat heat pipes, round heat pipes can first be installed by using an automation technology, and then subsequent aging and helium inspection tests can be performed on the basis of the round heat pipes. After the tests, the round heat pipes can be uniformly shaped into flat heat pipes. Therefore, while improving the production capacity of the three-dimensional heat dissipation devices with flat heat pipes, the relative stability of product quality can be, but is not required to be, improved.

The above description of the summary of the present disclosure and the following description of the example embodiments are used to illustrate and explain the principles of the present disclosure, and can facilitate further understanding of the appended claims of the present disclosure.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
FIG. 1 is a schematic structural diagram of a final three-dimensional heat dissipation device of an example embodiment of the present disclosure.
FIG. 2 is a flowchart of a manufacturing method of an example embodiment of the present disclosure.
FIG. 3 is a schematic structural diagram of a thermally conductive casing of an example embodiment of the present disclosure.
FIG. 4 is a detailed flowchart of step S1 in FIG. 2 of an example embodiment of the present disclosure.
FIG. 5 is a detailed flowchart of step S2 in FIG. 2 of an example embodiment of the present disclosure.
FIG. 6 is a detailed flowchart of step S3 in FIG. 2 of an example embodiment of the present disclosure.
FIG. 7 is an overall process flowchart of an example embodiment of the present disclosure.
FIG. 8 is a schematic structural diagram of a shaping mold of an example embodiment of the present disclosure.
FIG. 9 is an exploded structure of FIG. 8 of an example embodiment of the present disclosure.
FIG. 10 is a schematic structural diagram of a latch insert of an example embodiment of the present disclosure.

### DETAILED DESCRIPTION OF EXEMPLARY EMBODIMENTS

The matters exemplified in this description are provided to assist in a comprehensive understanding of exemplary embodiments of the disclosure. Accordingly, those of ordinary skill in the art will recognize that various changes and modifications of the embodiments described herein can be made without departing from the scope of the claims. Also, descriptions of well-known functions and constructions are omitted for clarity and conciseness.

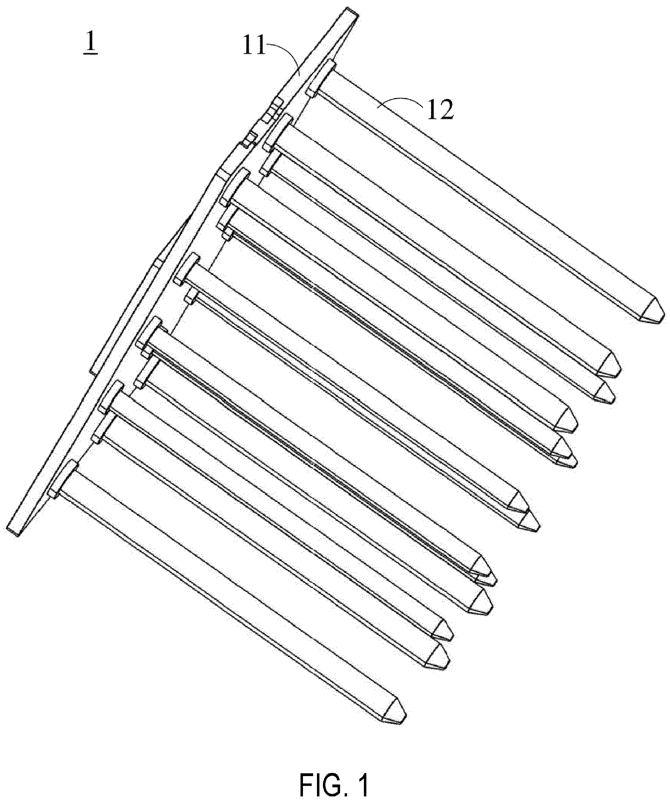

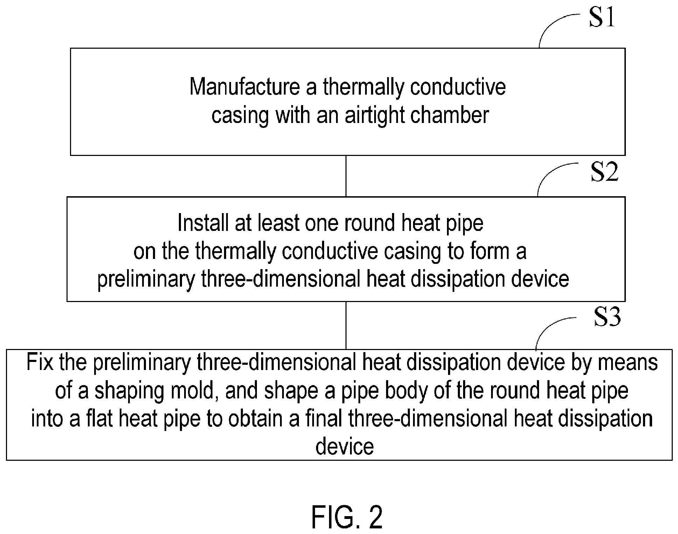

Referring to exemplary illustrations of FIGS. 1 and 2, FIG. 1 is a schematic structural diagram of a final three-dimensional heat dissipation device of an example embodiment of the present disclosure, and FIG. 2 is a flowchart of a manufacturing method of an example embodiment of the present disclosure. As shown in FIGS. 1 and 2, the final three-dimensional heat dissipation device 1 according to an example implementation of example embodiments can include a thermally conductive casing 11 and a flat heat pipe 12. In an example implementation, the flat heat pipe 12 can be installed on the thermally conductive casing 11. According to example embodiments, a manufacturing method for a three-dimensional heat dissipation device of the present disclosure can include:
a thermally conductive casing manufacturing step S1: manufacturing a thermally conductive casing 11 with an airtight chamber S1;
a preliminary three-dimensional heat dissipation device manufacturing step S2:
   installing at least one round heat pipe on the thermally conductive casing 11 to form a preliminary three-dimensional heat dissipation device; and
a final three-dimensional heat dissipation device manufacturing step S3: fixing the preliminary three-dimensional heat dissipation device by means of a shaping mold 2, and shaping a pipe body of the round heat pipe into a flat heat pipe 12 to obtain a final three-dimensional heat dissipation device 1.

According to exemplary implementations, on this basis, in the example embodiments of the present disclosure, by means of an automated pipe installation technology, the round heat pipe can be installed on the thermally conductive casing 11 to form the preliminary three-dimensional heat dissipation device, and then an aging test and a helium inspection test can be performed. After the tests, the pipe body of the round heat pipe can be shaped into a flat heat pipe 12 to obtain the final three-dimensional heat dissipation device 1, thereby facilitating the avoidance of deformation of the heat pipe during pipe installation and testing, and possibly improving the processing efficiency of the product.

It should be noted that, in an example implementation of above example embodiment, the manufacturing method can further include a test step of performing a temperature difference test on the final three-dimensional heat dissipation device.

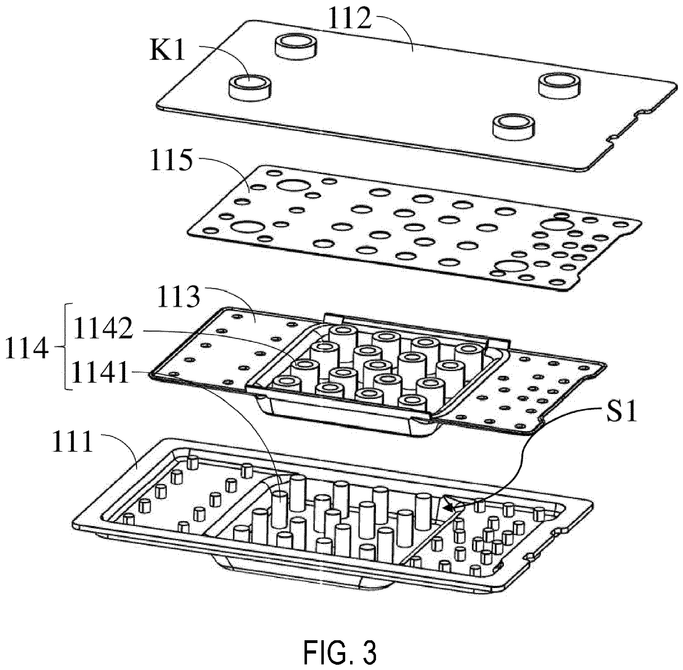

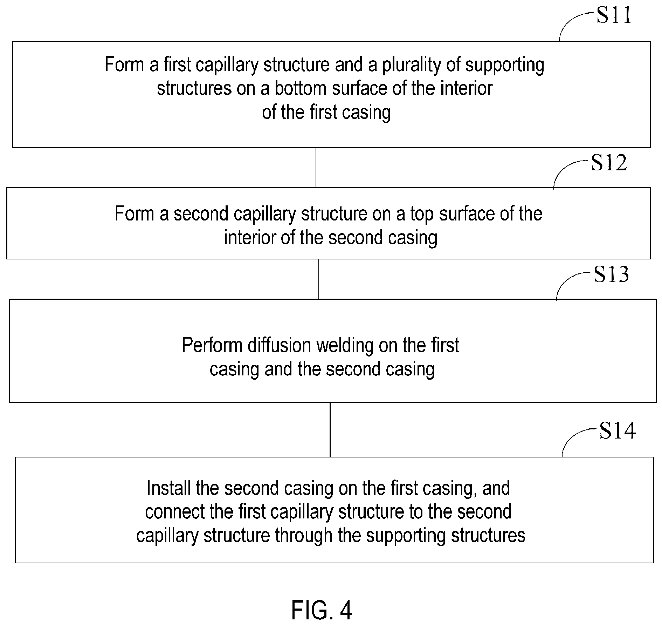

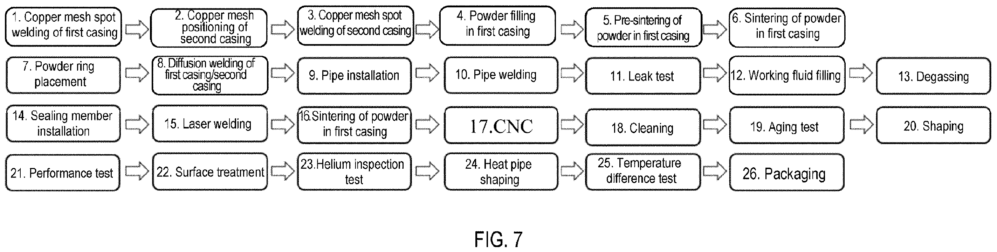

Referring to exemplary illustrations of FIGS. 3 to 4 and 7, FIG. 3 is a schematic structural diagram of a thermally conductive casing according to an example embodiment of the present disclosure, FIG. 4 is a detailed flowchart of step S1 in FIG. 2 according to an example implementation of example embodiments of the present disclosure, and FIG. 7 is an overall process flowchart of example embodiments of the present disclosure. As shown in FIGS. 3 and 4, in an example implementation the thermally conductive casing can include a first casing 111 and a second casing 112. The thermally conductive casing manufacturing step S1 according to an example implementation can include:
step S11: forming a first capillary structure 113 and a plurality of supporting structures 114 on the bottom surface of the interior of the first casing 111;
step S12: forming a second capillary structure 115 on the top surface of the interior of the second casing 112;
step S13: performing diffusion welding on the first casing 111 and the second casing 112; and
step S14: installing the second casing 112 on the first casing 111, and connecting the first capillary structure 113 to the second capillary structure 115 through the supporting structures 114.

In an exemplary implementation of disclosed example embodiments, step S11 of forming the first capillary structure and the plurality of supporting structures on the bottom surface of the interior of the first casing can include:
forming the first capillary structure 113 on the bottom surface of the interior of the first casing 111 by copper mesh spot welding;
filling metal powder on the bottom surface of the interior of the first casing 111 and then forming a supporting column 1141 of each supporting structure 114 by sintering; and
arranging a powder ring on the supporting column 1141 to form a third capillary structure 1142 of each supporting structure 114, the third capillary structure 1142 covering the outer surface of the supporting column 1141;
wherein when the second casing 112 can be installed on the first casing 111, the first capillary structure 113 can be connected to the second capillary structure 115 through the third capillary structure 1142.

It should be noted that, in an example implementation of above example embodiment, after the first capillary structure 113 is formed by copper mesh spot welding on the bottom surface of the interior of the first casing 111 in step S11, the supporting column 1141 and the third capillary structure 1142 can be formed. However, example embodiments of the present disclosure are not limited to this. In another example embodiment of the present disclosure, the supporting column 1141 and the third capillary structure 1142 may also be formed after step S12.

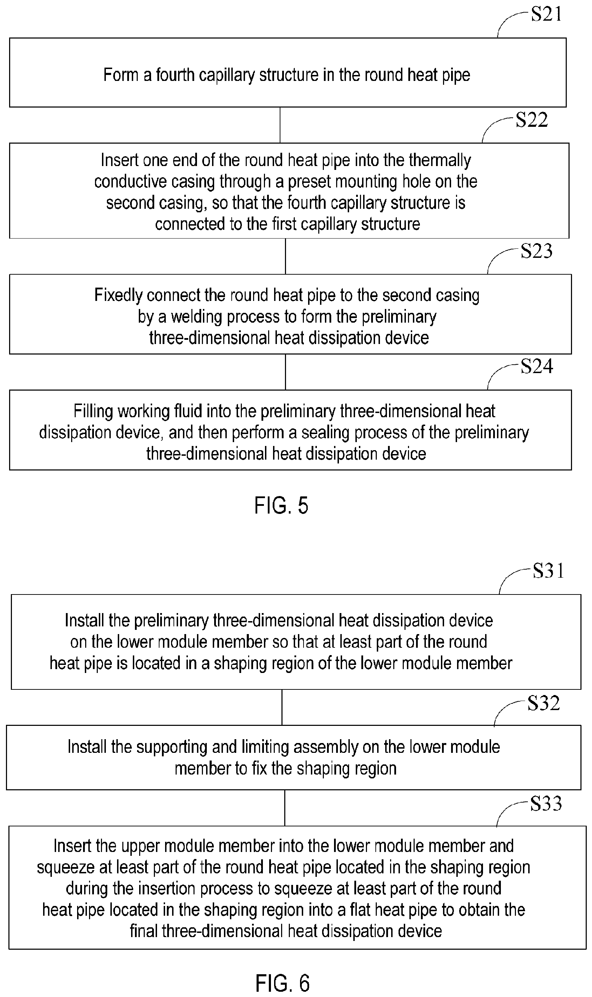

Referring to exemplary illustrations of FIGS. 5 and 7, FIG. 5 is a detailed flowchart of example implementation of step S2 in example embodiment illustrated in FIG. 2. As shown in FIGS. 5 and 7, according to exemplary implementation of example disclosed embodiments, the preliminary three-dimensional heat dissipation device manufacturing step S2 can include:
step S21: forming a fourth capillary structure in the round heat pipe;
step S22: inserting one end of the round heat pipe into the thermally conductive casing 11 through a preset mounting hole K1 on the second casing 112, so that the fourth capillary structure is connected to the first capillary structure 113;
step S23: fixedly connecting the round heat pipe to the second casing 112 by a welding process to form the preliminary three-dimensional heat dissipation device; and
step S24: filling working fluid into the preliminary three-dimensional heat dissipation device, and then performing a sealing process of the preliminary three-dimensional heat dissipation device.

In example embodiments of the present disclosure the number of heat pipes does not have to be limited, and the heat pipes can be distributed in an array on the second housing 112.

Further in example embodiments of the present disclosure, step S24 can further include, before filling the working fluid, performing a leak test on the preliminary three-dimensional heat dissipation device.

Still further, in example embodiments of the present disclosure the sealing process in step S24 can include:
performing a degassing process of the preliminary three-dimensional heat dissipation device after it is filled with the working fluid;
sealing a working fluid injection port (not shown) of the preliminary three-dimensional heat dissipation device by a sealing member; and
welding and sealing the connection between the first casing 111 and the second casing 112 by laser welding.

Yet still further, in example embodiments of the present disclosure the preliminary three-dimensional heat dissipation device manufacturing step S2 can further include:
cleaning the preliminary three-dimensional heat dissipation device after the sealing process, and performing an aging test, a performance test, a surface treatment and a helium inspection test.

It should be noted that, in example embodiment of the present disclosure, after the connection between the first casing 111 and the second casing 112 is welded and sealed by laser welding, the preliminary three-dimensional heat dissipation device can be shaped by means of a computer numerical control machining tool (CNC machining tool) to remove excess parts of the product. After shaping, the preliminary three-dimensional heat dissipation device after the sealing process can be cleaned, and subjected to an aging test, a performance test, a surface treatment and a helium inspection test.

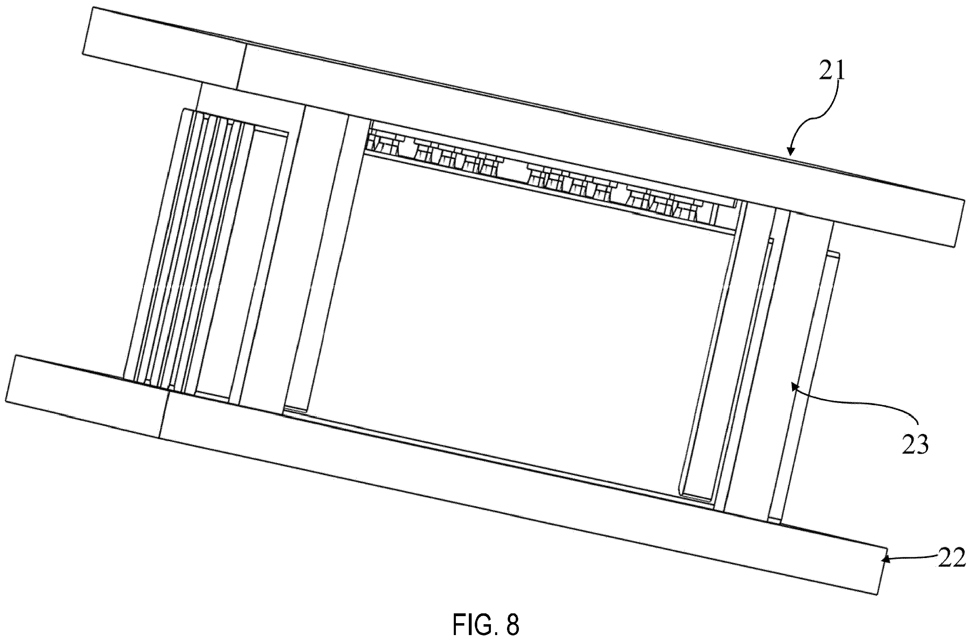

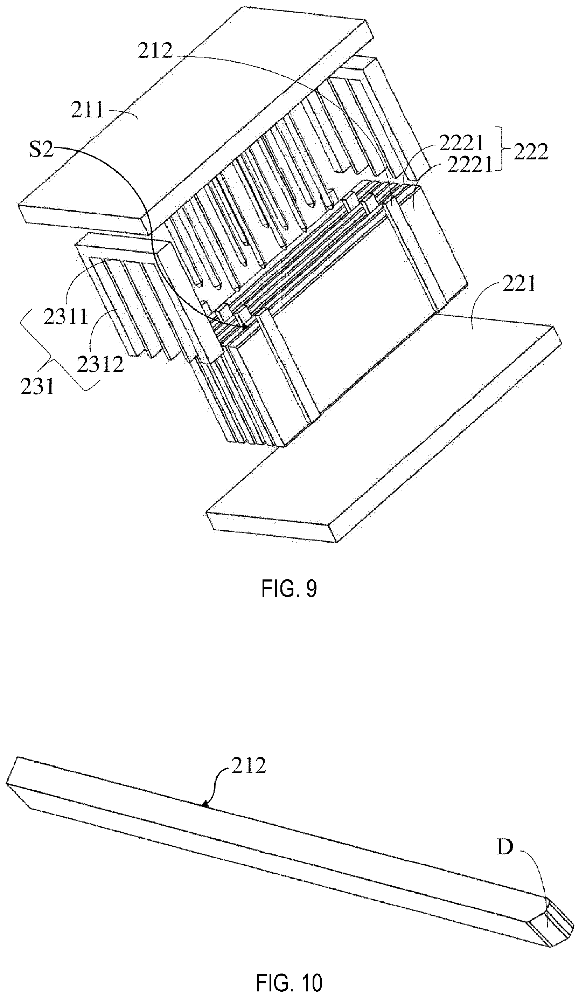

Referring to exemplary illustrations of FIGS. 6 to 7 and 8 to 9, FIG. 6 is a detailed flowchart of an example implementation of step S3 in example embodiment illustrated in FIG. 2, FIG. 8 is a schematic structural diagram of a shaping mold of an example embodiments of the present disclosure, and FIG. 9 is an exploded view of FIG. 8. As shown in exemplary illustrations of FIGS. 6 to 7 and 8 to 9, in an example implementation the shaping mold 2 can includes an upper module member 21, a lower module member 22 and a supporting and limiting assembly 23. According to an example embodiment, the final three-dimensional heat dissipation device manufacturing step S3 can include:
step S31: installing the preliminary three-dimensional heat dissipation device on the lower module member 22 so that at least part of the round heat pipe can be located in a shaping region S2 of the lower module member 22;
step S32: installing the supporting and limiting assembly 23 on the lower module member 22 to fix the shaping region S2; and
step S33: inserting the upper module member 21 into the lower module member 22 and squeezing at least part of the round heat pipe located in the shaping region S2 during the insertion process to squeeze at least part of the round heat pipe located in the shaping region S2 into a flat heat pipe to obtain the final three-dimensional heat dissipation device.

Further, in an example implementation of disclosed example embodiments, the lower module member 22 can include a lower mold plate 221 and at least one shaping insert group 222. In an example implementation, the shaping insert groups 22 can be installed on the lower mold plate 221 at intervals. In an example implementation, each shaping insert group 222 can include two shaping inserts 2221, the two shaping inserts 2221 can be arranged opposite to each other and there can be the shaping region S2 between the two shaping inserts 2221. In an example implementation of disclosed example embodiments,, step 31 of installing the preliminary three-dimensional heat dissipation device on the lower module so that at least part of the round heat pipe can be located in the shaping region of the lower module can include: arranging at least part of the round heat pipe in the shaping region S2 between the two shaping inserts 2221.

Still further, in an example implementation of disclosed example embodiments, the supporting and limiting assembly 23 can include at least one supporting and limiting member 231. In an example implementation, the supporting and limiting member can include a transverse portion 2311 and a plurality of vertical portions 2312 arranged at intervals. In an example implementation, one end of each vertical portion 2312 can be connected to the transverse portion 2311. In an example implementation of disclosed example embodiments, step S32 of installing the supporting and limiting assembly on the lower module to fix the shaping region can include:
inserting the other end of the vertical portion 2312 into a gap between the shaping insert groups 222 in an aligned manner so that it is located on the outer sides of the molding insert groups 222 on both sides and abuts against the lower mold plate 221; and
arranging the transverse portion 2311 on the upper surfaces of the shaping inserts 2221.

Still further, in an example implementation of disclosed example embodiments, the upper module member 21 can include an upper mold plate 211 and a plurality of latch inserts 212. In an example implementation, the latch inserts 212 can be installed on the upper mold plate 211. In an example implementation of disclosed example embodiments, step S33 of inserting the upper module into the lower module and squeezing at least part of the round heat pipe located in the shaping region during the insertion process to squeeze at least part of the round heat pipe located in the shaping region into the flat heat pipe to obtain the final three-dimensional heat dissipation device can include:
inserting the latch insert 212 into a gap between the shaping insert groups 222 in an aligned manner so that it is located on the outer sides of the shaping insert groups 222 at both sides;
squeezing two shaping inserts 2221 of each shaping insert group 222 simultaneously by means of the latch insert 212 during the insertion process; and
squeezing at least part of the round heat pipe by the two shaping inserts 2221 moving toward each other when being squeezed so that at least part of the round heat pipe can be squeezed into the flat heat pipe 12.

In an example implementation of disclosed example embodiments, during the insertion process, the insertion length of the latch insert 212 can be limited by the supporting and limiting member 231. In certain example implementations, when the upper mold plate 211 moves downward until it abuts against the transverse portion 2311, the squeezing process ends.

In an example embodiment of the present disclosure, the thickness of the latch insert 212 can be less than or equal to the radius of the round heat pipe.

In an example embodiment of the present disclosure, an end of the latch insert 212 for insertion can be wedge-shaped.

Refer to exemplary illustrations of FIGS. 8 to 9. As shown in FIGS. 8 to 9, an example implementation of disclosed example embodiments further provides a shaping mold. The shaping mold can be used in the above manufacturing method of example disclosed embodiments to shape a preliminary three-dimensional heat dissipation device. According to example implementations, the preliminary three-dimensional heat dissipation device can include a thermally conductive casing and a round heat pipe installed on the thermally conductive casing. According to example implementations, the preliminary three-dimensional heat dissipation device can be fixed by means of the shaping mold 2, and the pipe body of the round heat pipe of the preliminary three-dimensional heat dissipation device can be shaped into a flat heat pipe 12 to obtain a final three-dimensional heat dissipation device.

According to example implementation of disclosed example embodiments, the shaping mold 2 can include an upper module member 21, a lower module member 22 and a supporting and limiting assembly 23. In an example implementation, the preliminary three-dimensional heat dissipation device can be installed on the lower module member 22 so that at least part of the round heat pipe can be located in the shaping region S2 of the lower module member 22. In an example implementation, the supporting and limiting assembly 23 can be installed on the lower module member 21 to fix the shaping region S2. In an example implementation, the upper module member 21 can be used to insert the lower module member 22. According to example implementation of disclosed example embodiments, during the insertion process, at least part of the round heat pipe located in the shaping region S2 can be squeezed to squeeze at least part of the round heat pipe located in the shaping region S2 into a flat heat pipe to obtain the final three-dimensional heat dissipation device.

Further, according to example implementation of disclosed example embodiments, the lower module member can include a lower mold plate 221 and at least one shaping insert group 222. In an example implementation, the shaping insert groups 222 can be installed on the lower mold plate 221 at intervals. In an example implementation, each shaping insert group 222 can include two shaping inserts 2221. In an example implementation, the two shaping inserts 2221 can be arranged opposite to each other, and there can be a shaping region S2 between the two shaping inserts 2221. In an example implementation, at least part of the round heat pipe can be arranged in the shaping region S2 between the two shaping inserts 2221.

In an example implementation of the above disclosed example embodiment, the lower mold plate 221 and the insert groups 222 can be separate structures. In another example embodiment of the present disclosure, the lower mold plate 221 and the insert groups 222 can be an integrated structure.

Still further, according to example implementation of disclosed example embodiments, the supporting and limiting assembly 23 can include at least one supporting and limiting member 231. In an example implementation, the supporting and limiting member can include a transverse portion 2311 and a plurality of vertical portions 2312 arranged at intervals. In an example implementation, one end of each vertical portion 2312 can be connected to the transverse portion 2311, and the other end of the vertical portion 2312 can be inserted into the gap between the shaping insert groups 222 so that it can be located on the outer sides of the shaping insert groups 222 on both sides and abut against the lower mold plate 221. In an example implementation, the transverse portion 2311 can be arranged on the upper surfaces of the shaping inserts 2221.

Still further, according to example implementation of disclosed example embodiments, the upper module member 21 can include an upper mold plate 211 and a plurality of latch inserts 212. In an example implementation, the latch inserts 212 can be installed on the upper mold plate 211. In an example implementation, the upper module member 21 can be inserted into the lower module member 22, and during the insertion process, at least part of the round heat pipe located in the shaping region S2 can be squeezed, so that at least part of the round heat pipe located in the shaping region S2 can be squeezed into a flat heat pipe. In an example implementation, each latch insert 212 can be inserted into a gap between the shaping insert groups 222 in an aligned manner so that it can be located on the outer sides of the shaping insert groups 222 on both sides. According to example implementation of disclosed example embodiments, during the insertion process, two shaping inserts 2221 of each shaping insert group 222 can be squeezed simultaneously by means of the latch insert 212. In an example implementation, the two shaping inserts 2221 move toward each other when being squeezed to squeeze at least part of the round heat pipe, so that at least part of the round heat pipe can be squeezed into a flat heat pipe 12. In an example implementation, during the insertion process, the insertion length of the latch insert 212 can be limited by the supporting and limiting member 231.

In an example implementation of the above disclosed example embodiment, the upper mold plate 211 and the latch inserts 212 can be separate structures. In another example embodiment of the present disclosure, the upper mold plate 211 and the latch inserts 212 can be an integrated structure.

In an example embodiment of the present disclosure, the thickness of the latch inserts 212 can be less than or equal to the radius of the round heat pipe.

In an example embodiment of the present disclosure, an end D of the latch insert 212 for insertion can be wedge-shaped, as shown in FIG. 10.

In summary, on the basis of the example embodiments of the present disclosure, when manufacturing three-dimensional heat dissipation devices with flat heat pipes, round heat pipes can first be installed by using an automation technology, and then subsequent aging and helium inspection tests can be performed on the basis of the round heat pipes. After the tests, the round heat pipes can be uniformly shaped into flat heat pipes. Therefore, while facilitating improvement of the production capacity of the three-dimensional heat dissipation devices with flat heat pipes, the relative stability of product quality can be improved.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although the present disclosure has been disclosed as above with reference to the aforementioned example and/or preferred embodiments, such embodiments are not intended to limit the present disclosure. Any person skilled in the art may make some changes and modifications without departing from the scope of the present disclosure. Therefore, the scope of patent protection of the present disclosure shall be defined by the scope of the claims appended to this description.

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
1: Final three-dimensional heat dissipation device
11: Thermally conductive casing
S1: Airtight chamber
111: First casing
112: Second casing
K1: Mounting hole
113: First capillary structure
114: Supporting structure
1141: Supporting column
1142: Third capillary structure
115: Second capillary structure
12: Flat heat pipe
2: Shaping mold
21: Upper module member
211: Upper mold plate
212: Latch insert
22: Lower module member
221: Lower mold plate
222: Shaping insert group
2221: Shaping insert
S2: Shaping region
23: Supporting and limiting assembly
231: Supporting and limiting member
2311: Transverse portion
2312: Vertical portion
S1 to S3: Step
S11 to S14: Step
S21 to S24: Step
S31 to S33: Step

## Claims

1. A manufacturing method for a three-dimensional heat dissipation device (1), the method comprising:
a thermally conductive casing manufacturing step (S1) comprising manufacturing a thermally conductive casing (11) with an airtight chamber;
a preliminary three-dimensional heat dissipation device manufacturing step (S2) comprising installing at least one round heat pipe on the thermally conductive casing (11) to form a preliminary three-dimensional heat dissipation device; and
a final three-dimensional heat dissipation device manufacturing step (S3) comprising fixing the preliminary three-dimensional heat dissipation device by means of a shaping mold (2),
**characterised in** shaping a pipe body of the round heat pipe into a flat heat pipe (12) to obtain a final three-dimensional heat dissipation device (1).

2. The manufacturing method as claimed in claim 1, wherein the thermally conductive casing (11) comprises a first casing (111) and a second casing (112), and the thermally conductive casing manufacturing step (S1) comprises:
forming a first capillary structure (113) and a plurality of supporting structures (114) on a bottom surface of the interior of the first casing (111);
forming a second capillary structure (115) on a top surface of the interior of the second casing (112);
performing diffusion welding (S13) on the first casing (111) and the second casing (112); and
installing the second casing (112) on the first casing (111), and connecting the first capillary structure (113) to the second capillary structure (115) through the supporting structures (114).

3. The manufacturing method as claimed in claim 2, wherein the step of forming the first capillary structure (113) and the plurality of supporting structures (114) on the bottom surface of the interior of the first casing (111) comprises:
forming the first capillary structure (113) on the bottom surface of the interior of the first casing (111) by copper mesh spot welding;
filling metal powder on the bottom surface of the interior of the first casing (111) and then forming a supporting column (1141) of each supporting structure (114) by sintering; and
arranging a powder ring on the supporting column (1141) to form a third capillary structure (1142) of each supporting structure (114), the third capillary structure (1142) covering an outer surface of the supporting column (1141);
wherein when the second casing (112) is installed on the first casing (111), the first capillary structure (113) is connected to the second capillary structure (115) through the third capillary structure (1142).

4. The manufacturing method as claimed in claim 2, wherein the preliminary three-dimensional heat dissipation device manufacturing step (S2) comprises:
forming a fourth capillary structure in the round heat pipe;
inserting one end of the round heat pipe into the thermally conductive casing (11) through a preset mounting hole (K1) on the second casing (112), so that the fourth capillary structure is connected to the first capillary structure (113);
fixedly connecting the round heat pipe to the second casing (112) by a welding process to form the preliminary three-dimensional heat dissipation device; and
filling working fluid into the preliminary three-dimensional heat dissipation device, and then performing a sealing process of the preliminary three-dimensional heat dissipation device.

5. The manufacturing method as claimed in one of claims 1 to 4, wherein the shaping mold (2) comprises an upper module member (21), a lower module member (22) and a supporting and limiting assembly (23), and the final three-dimensional heat dissipation device manufacturing step (S3) comprises:
installing the preliminary three-dimensional heat dissipation device on the lower module member (22) so that at least part of the round heat pipe is located in a shaping region of the lower module member (22);
installing the supporting and limiting assembly (23) on the lower module member (22) to fix the shaping region; and
inserting the upper module member (21) into the lower module member (22) and squeezing at least part of the round heat pipe located in the shaping region during the insertion process to squeeze at least part of the round heat pipe located in the shaping region into a flat heat pipe (12) to obtain the final three-dimensional heat dissipation device (1).

6. The manufacturing method as claimed in claim 5, wherein the lower module member (22) comprises a lower mold plate (221) and at least one shaping insert group (222), the shaping insert groups (222) are installed on the lower mold plate (221) at intervals, each shaping insert group (222) comprises two shaping inserts (2221), the two shaping inserts (2221) are arranged opposite to each other and there is the shaping region between the two shaping inserts (2221), and the step of installing the preliminary three-dimensional heat dissipation device on the lower module so that at least part of the round heat pipe is located in the shaping region of the lower module comprises:
arranging at least part of the round heat pipe in the shaping region between the two shaping inserts (2221).

7. The manufacturing method as claimed in claim 6, wherein the supporting and limiting assembly (23) comprises at least one supporting and limiting member (231), the supporting and limiting member (231) comprises a transverse portion (2311) and a plurality of vertical portions (2312) arranged at intervals, one end of each vertical portion (2312) is connected to the transverse portion (2311), and the step of installing the supporting and limiting assembly (23) on the lower module to fix the shaping region comprises:
inserting the other end of the vertical portion (2312) into a gap between the shaping insert groups (222) in an aligned manner so that the vertical portion (2312) is located on the outer sides of the molding insert groups (222) on both sides and abuts against the lower mold plate (221); and
arranging the transverse portion (2311) on the upper surfaces of the shaping inserts (2221).

8. The manufacturing method as claimed in claim 7, wherein the upper module member (21) comprises an upper mold plate (211) and a plurality of latch inserts (212), the latch inserts (212) are installed on the upper mold plate (211), and the step of inserting the upper module into the lower module and squeezing at least part of the round heat pipe located in the shaping region during the insertion process to squeeze at least part of the round heat pipe located in the shaping region into the flat heat pipe (12) to obtain the final three-dimensional heat dissipation device (1) comprises:
inserting the latch insert (212) into a gap between the shaping insert groups (222) in an aligned manner so that the latch insert (212) is located on the outer sides of the shaping insert groups (222) at both sides;
squeezing two shaping inserts (2221) of each shaping insert group (222) simultaneously by means of the latch insert (212) during the insertion process; and
squeezing at least part of the round heat pipe by the two shaping inserts (2221) moving toward each other when being squeezed so that at least part of the round heat pipe is squeezed into the flat heat pipe (12),
wherein an insertion length of the latch insert (212) is limited by the supporting and limiting member (231) during the insertion process.

9. The manufacturing method as claimed in claim 8, wherein a thickness of the latch insert (212) is less than or equal to a radius of the round heat pipe.

10. The manufacturing method as claimed in claim 8 or 9, wherein an end of the latch insert (212) for insertion is wedge-shaped.

11. The manufacturing method as claimed in claim 4, wherein the preliminary three-dimensional heat dissipation device manufacturing step (S2) further comprises:
before filling the working fluid, performing a leak test on the preliminary three-dimensional heat dissipation device.

12. The manufacturing method as claimed in claim 4, wherein the sealing process comprises:
performing a degassing process of the preliminary three-dimensional heat dissipation device after being filled with the working fluid;
sealing a working fluid injection port of the preliminary three-dimensional heat dissipation device by a sealing member; and
welding and sealing the connection between the first casing (111) and the second casing (112) by laser welding.

13. The manufacturing method as claimed in claim 4, wherein the preliminary three-dimensional heat dissipation device manufacturing step (S2) further comprises:
cleaning the preliminary three-dimensional heat dissipation device after the sealing process, and performing an aging test, a performance test, a surface treatment and a helium inspection test.

14. The manufacturing method as claimed in claim 4, further comprising:
a test step comprising performing a temperature difference test on the final three-dimensional heat dissipation device (1).

15. A shaping mold (2) comprising:
a body configured to shape a preliminary three-dimensional heat dissipation device,
wherein the preliminary three-dimensional heat dissipation device comprises a thermally conductive casing (11) and a round heat pipe installed on the thermally conductive casing (11), and the preliminary three-dimensional heat dissipation device is fixed by the shaping mold (2),
wherein the mold allows a pipe body of the round heat pipe of the preliminary three-dimensional heat dissipation device to be shaped into a flat heat pipe (12) to obtain a final three-dimensional heat dissipation device (1).

16. The shaping mold as claimed in claim 15, wherein the shaping mold (2) comprises:
a lower module member (22) of said body, the preliminary three-dimensional heat dissipation device being installed on said lower module member (22) so that at least part of the round heat pipe is located in a shaping region of the lower module member (22);
a supporting and limiting assembly (23) installed on the lower module member (22) to fix the shaping region; and
an upper module member (21) for inserting the lower module member (22) and squeezing at least part of the round heat pipe located in the shaping region during the insertion process to squeeze at least part of the round heat pipe located in the shaping region into a flat heat pipe (12) to obtain the final three-dimensional heat dissipation device (1).

17. The shaping mold as claimed in claim 16, wherein the lower module member (22) comprises:
a lower mold plate (221); and
at least one shaping insert group (222), wherein the shaping insert groups (222) are installed on the lower mold plate (221) at intervals, each shaping insert group (222) comprises two shaping inserts (2221), the two shaping inserts (2221) are arranged opposite to each other, and there is a shaping region between the two shaping inserts (2221), and at least part of the round heat pipe is arranged in the shaping region between the two shaping inserts (2221).

18. The shaping mold as claimed in claim 17, wherein
the supporting and limiting assembly (23) comprises at least one supporting and limiting member (231);
the supporting and limiting member (231) comprises a transverse portion (2311) and a plurality of vertical portions (2312) arranged at intervals;
one end of each vertical portion (2312) is connected to the transverse portion (2311), and the other end of the vertical portion (2312) is inserted into the gap between the shaping insert groups (222) so that the vertical portion (2312) is located on the outer sides of the shaping insert groups (222) on both sides and abuts against the lower mold plate (221); and
the transverse portion (2311) is arranged on the upper surfaces of the shaping inserts (2221).

19. The shaping mold as claimed in claim 18, wherein the upper module member (21) comprises:
an upper mold plate (211); and
a plurality of latch inserts (212) installed on the upper mold plate (211), wherein the upper module is inserted into the lower module, and at least part of the round heat pipe located in the shaping region is squeezed during the insertion process to squeeze at least part of the round heat pipe located in the shaping region into the flat heat pipe (12);
wherein each latch insert (212) is inserted into a gap between the shaping insert groups (222) in an aligned manner, and is located on the outer sides of the shaping insert groups (222) on both sides; during the insertion process, two shaping inserts (2221) of each shaping insert group (222) are squeezed simultaneously by means of the latch insert (212); the two shaping inserts (2221) move toward each other when being squeezed to squeeze at least part of the round heat pipe, so that at least part of the round heat pipe is squeezed into a flat heat pipe (12); and during the insertion process, an insertion length of the latch insert (212) is limited by the supporting and limiting member (231).

20. The shaping mold as claimed in claim 19, wherein a thickness of the latch insert (212) is less than or equal to a radius of the round heat pipe.

21. The shaping mold as claimed in claim 18, wherein an end of the latch insert (212) for insertion is wedge-shaped.

## Patentansprüche

1. Herstellungsverfahren für eine dreidimensionalen Wärmeableitvorrichtung (1), wobei das Verfahren umfasst:
einen Verfahrensschritt (S1) zur Herstellung eines wärmeleitenden Gehäuses, umfassend das Herstellen eines wärmeleitenden Gehäuses (11) mit einer luftdichten Kammer;
einen Verfahrensschritt zur Herstellung einer vorläufigen dreidimensionalen Wärmeableitvorrichtung (S2), umfassend das Anbringen mindestens eines runden Wärmerohrs an dem wärmeleitenden Gehäuse (11), um eine vorläufige dreidimensionale Wärmeableitvorrichtung zu bilden; und
einen Verfahrensschritt (S3) zur Herstellung einer finalen dreidimensionalen Wärmeableitvorrichtung, umfassend das Fixieren der vorläufigen dreidimensionalen Wärmeableitvorrichtung mittels eines Formwerkzeugs (2),
**dadurch gekennzeichnet, dass** ein Rohrkörper des runden Wärmerohrs zu einem flachen Wärmerohr (12) geformt wird, um eine finale dreidimensionale Wärmeableitvorrichtung (1) zu erhalten.

2. Herstellungsverfahren nach Anspruch 1, wobei das wärmeleitende Gehäuse (11) ein erstes Gehäuse (111) und ein zweites Gehäuse (112) umfasst, und der Verfahrensschritt (S1) zur Herstellung des wärmeleitenden Gehäuses Folgendes umfasst:
Bilden einer ersten Kapillarstruktur (113) und einer Vielzahl von Stützstrukturen (114) an einer Unterseite im Inneren des ersten Gehäuses (111);
Bilden einer zweiten Kapillarstruktur (115) an einer Oberseite im Inneren des zweiten Gehäuses (112);
Durchführen von Diffusionsschweißen (S13) an dem ersten Gehäuse (111) und dem zweiten Gehäuse (112); und
Anbringen des zweiten Gehäuses (112) am ersten Gehäuse (111) und Verbinden der ersten Kapillarstruktur (113) mit der zweiten Kapillarstruktur (115) mittels der Stützstrukturen (114).

3. Herstellungsverfahren nach Anspruch 2 wobei der Schritt des Ausbildens der ersten Kapillarstruktur (113) und der Mehrzahl von Stützstrukturen (114) an der Bodenfläche des Inneren des ersten Gehäuses (111) umfasst:
Bilden der ersten Kapillarstruktur (113) an der Unterseite des Inneren des ersten Gehäuses (111) durch Punktschweißen von Kupfergewebe;
Einfüllen von Metallpulver auf die Unterseite des Inneren des ersten Gehäuses (111) und anschließendes Ausbilden einer Stützsäule (1141) jeder Stützstruktur (114) durch Sintern; und
Anordnen eines Pulverrings auf der Stützsäule (1141), um eine dritte Kapillarstruktur (1142) jeder Stützstruktur (114) zu bilden, wobei die dritte Kapillarstruktur (1142) eine Außenfläche der Stützsäule (1141) bedeckt;
wobei, wenn das zweite Gehäuse (112) auf dem ersten Gehäuse (111) angebracht ist, die erste Kapillarstruktur (113) mittels der dritten Kapillarstruktur (1142) mit der zweiten Kapillarstruktur (115) verbunden ist.

4. Herstellungsverfahren nach Anspruch 2, wobei der Verfahrensschritt zur Herstellung einer vorläufigen dreidimensionalen Wärmeableitvorrichtung (S2) Folgendes umfasst:
Ausbilden einer vierten Kapillarstruktur in dem runden Wärmerohr;
Einführen eines Endes des runden Wärmerohrs in das wärmeleitende Gehäuse (11) durch eine vorbestimmte Befestigungsöffnung (K1) am zweiten Gehäuse (112), so dass die vierte Kapillarstruktur mit der ersten Kapillarstruktur (113) verbunden ist;
festes Verbinden des runden Wärmerohrs mit dem zweiten Gehäuse (112) durch ein Schweißverfahren, um die vorläufige dreidimensionale Wärmeableitvorrichtung zu bilden; und
Einfüllen von Arbeitsfluid in die vorläufige dreidimensionale Wärmeableitvorrichtung und anschließendes Durchführen eines Abdichtvorgangs der vorläufigen dreidimensionalen Wärmeableitvorrichtung.

5. Herstellungsverfahren nach einem der Ansprüche 1 bis 4, wobei das Formwerkzeug (2) ein oberes Modulelement (21), ein unteres Modulelement (22) und eine Stütz- und Begrenzungsbaugruppe (23) umfasst, und der Verfahrensschritt (S3) zur Herstellung der finalen dreidimensionalen Wärmeableitvorrichtung umfasst:
Anbringen der vorläufigen dreidimensionalen Wärmeableitvorrichtung an dem unteren Modulelement (22), so dass sich zumindest ein Teil des runden Wärmerohrs in einem Formgebungsbereich des unteren Modulelements (22) befindet;
Anbringen der Stütz- und Begrenzungsbaugruppe (23) am unteren Modulelement (22) zur Fixierung des Formgebungsbereichs; und
Einsetzen des oberen Modulelements (21) in das untere Modulelement (22) und Zusammendrücken zumindest eines Teils des runden Wärmerohrs, das sich im Formgebungsbereich befindet, während des Einsetzvorgangs, um zumindest einen Teil des runden Wärmerohrs, das sich im Formgebungsbereich befindet, zu einem flachen Wärmerohr (12) zusammenzudrücken, um die finale dreidimensionale Wärmeableitvorrichtung (1) zu erhalten.

6. Herstellungsverfahren nach Anspruch 5, wobei das untere Modulelement (22) eine untere Formplatte (221) und mindestens eine Formgebungseinsatzgruppe (222) umfasst, die Formgebungseinsatzgruppen (222) in Abständen auf der unteren Formplatte (221) angebracht sind, jede Formgebungseinsatzgruppe (222) zwei Formgebungseinsätze (2221) umfasst, die beiden Formgebungseinsätze (2221) einander gegenüberliegend angeordnet sind und sich der Formgebungsbereich zwischen den beiden Formgebungseinsätzen (2221) befindet, und der Schritt des Anbringens der vorläufigen dreidimensionalen Wärmeableitvorrichtung an dem unteren Modul, so dass sich zumindest ein Teil des runden Wärmerohrs in dem Formgebungsbereich des unteren Moduls befindet, umfasst:
Anordnen mindestens eines Teils des runden Wärmerohrs in dem Formgebungsbereich zwischen den beiden Formgebungseinsätzen (2221).

7. Herstellungsverfahren nach Anspruch 6, wobei die Stütz- und Begrenzungsbaugruppe (23) mindestens ein Stütz- und Begrenzungselement (231) umfasst, das Stütz- und Begrenzungselement (231) einen Querabschnitt (2311) und mehrere in Abständen angeordnete vertikale Abschnitte (2312) umfasst, wobei ein Ende jedes vertikalen Abschnitts (2312) mit dem Querabschnitt (2311) verbunden ist, und der Schritt des Anbringens der Stütz- und Begrenzungsbaugruppe (23) an dem unteren Modul zur Fixierung des Formgebungsbereichs umfasst:
Einführen des anderen Endes des vertikalen Abschnitts (2312) in einen Spalt zwischen den Formgebungseinsatzgruppen (222) in einer ausgerichteten Weise, so dass sich der vertikale Abschnitt (2312) auf beiden Seiten an den Außenseiten der Formgebungseinsatzgruppen (222) befindet und an der unteren Formplatte (221) anliegt; und
Anordnen des Querabschnitts (2311) auf den Oberseiten der Formgebungseinsätze (2221).

8. Herstellungsverfahren nach Anspruch 7, wobei das obere Modulelement (21) eine obere Formplatte (211) und mehrere Verriegelungseinsätze (212) umfasst, wobei die Verriegelungseinsätze (212) an der oberen Formplatte (211) angebracht sind, und der Schritt des Einsetzens des oberen Moduls in das untere Modul und des Zusammendrückens zumindest eines Teils des runden Wärmerohrs, das sich während des Einführvorgangs im Formgebungsbereich befindet, um zumindest einen Teil des runden Wärmerohrs, das sich im Formgebungsbereich befindet, in das flache Wärmerohr (12) zusammenzudrücken, um die finale dreidimensionale Wärmeableitvorrichtung (1) zu erhalten, umfasst:
Einführen des Verriegelungseinsatzes (212) in einen Spalt zwischen den Formgebungseinsatzgruppen (222) in einer ausgerichteten Weise, sodass sich der Verriegelungseinsatz (212) an beiden Seiten an den Außenseiten der Formgebungseinsatzgruppen (222) befindet;
gleichzeitiges Zusammendrücken von zwei Formgebungseinsätzen (2221) jeder Formgebungseinsatzgruppe (222) mittels des Verriegelungseinsatzes (212) während des Einführvorgangs; und
Zusammendrücken zumindest eines Teils des runden Wärmerohrs durch die beiden Formgebungseinsätze (2221), die sich beim Zusammendrücken aufeinander zu bewegen, so dass zumindest ein Teil des runden Wärmerohrs in das flache Wärmerohr (12) zusammengedrückt wird,
wobei eine Einführlänge des Verriegelungseinsatzes (212) während des Einführvorgangs durch das Stütz- und Begrenzungselement (231) begrenzt wird.

9. Herstellungsverfahren nach Anspruch 8, wobei eine Dicke des Verriegelungseinsatzes (212) kleiner oder gleich einem Radius des runden Wärmerohrs ist.

10. Herstellungsverfahren nach Anspruch 8 oder 9, wobei ein zum Einsetzen bestimmtes Ende des Verriegelungseinsatzes (212) keilförmig ist.

11. Herstellungsverfahren nach Anspruch 4, wobei der Verfahrensschritt (S2) zur Herstellung einer vorläufigen dreidimensionalen Wärmeableitvorrichtung ferner umfasst:
Durchführen einer Dichtheitsprüfung an der vorläufigen dreidimensionalen Wärmeableitvorrichtung vor dem Einfüllen des Arbeitsfluids.

12. Herstellungsverfahren nach Anspruch 4, wobei der Abdichtvorgang umfasst:
Durchführung eines Entgasungsvorgangs der vorläufigen dreidimensionalen Wärmeableitvorrichtung, nachdem diese mit dem Arbeitsfluid befüllt wurde;
Abdichten einer Arbeitsfluid-Einfüllöffnung der vorläufigen dreidimensionalen Wärmeableitvorrichtung mittels eines Dichtungselements; und
Verschweißen und Abdichten der Verbindung zwischen dem ersten Gehäuse (111) und dem zweiten Gehäuse (112) durch Laserschweißen.

13. Herstellungsverfahren nach Anspruch 4, wobei der Verfahrensschritt (S2) zur Herstellung einer vorläufigen dreidimensionalen Wärmeableitvorrichtung ferner umfasst:
Reinigen der vorläufigen dreidimensionalen Wärmeableitvorrichtung nach dem Abdichtvorgang sowie Durchführen eines Alterungstests, eines Leistungstests, einer Oberflächenbehandlung und einer Heliumprüfung.

14. Herstellungsverfahren nach Anspruch 4, ferner umfassend:
einen Testschritt, der die Durchführung eines Temperaturdifferenz-Tests an der finalen dreidimensionalen Wärmeableitvorrichtung (1) umfasst.

15. Formwerkzeug (2), umfassend:
einen Körper, der so konfiguriert ist, dass er eine vorläufige dreidimensionale Wärmeableitvorrichtung formt, wobei die vorläufige dreidimensionale Wärmeableitvorrichtung ein wärmeleitendes Gehäuse (11) und ein auf dem wärmeleitenden Gehäuse (11) angebrachtes rundes Wärmerohr umfasst, und die vorläufige dreidimensionale Wärmeableitvorrichtung durch das Formwerkzeug (2) fixiert ist,
wobei das Formwerkzeug es ermöglicht, einen Rohrkörper des runden Wärmerohrs der vorläufigen dreidimensionalen Wärmeableitvorrichtung zu einem flachen Wärmerohr (12) zu formen, um eine finale dreidimensionale Wärmeableitvorrichtung (1) zu erhalten.

16. Formwerkzeug nach Anspruch 15, wobei das Formwerkzeug (2) umfasst:
ein unteres Modulelement (22) des Körpers, wobei die vorläufige dreidimensionale Wärmeableitvorrichtung an dem unteren Modulelement (22) so angebracht ist, dass sich zumindest ein Teil des runden Wärmerohrs in einem Formgebungsbereich des unteren Modulelements (22) befindet;
eine Stütz- und Begrenzungsbaugruppe (23), die an dem unteren Modulelement (22) angebracht ist, um den Formgebungsbereich zu fixieren; und
ein oberes Modulelement (21) zum Einführen des unteren Modulelements (22) und zum Zusammendrücken zumindest eines Teils des runden Wärmerohrs, das sich im Formgebungsbereich befindet, während des Einführvorgangs, um zumindest einen Teil des runden Wärmerohrs, das sich im Formgebungsbereich befindet, zu einem flachen Wärmerohr (12) zusammenzudrücken, um die finale dreidimensionale Wärmeableitvorrichtung (1) zu erhalten.

17. Formwerkzeug nach Anspruch 16, wobei das untere Modulelement (22) umfasst:
eine untere Formplatte (221); und
mindestens eine Formgebungseinsatzgruppe (222), wobei die Formgebungseinsatzgruppen (222) in Abständen auf der unteren Formplatte (221) angebracht sind, jede Formgebungseinsatzgruppe (222) zwei Formgebungseinsätze (2221) umfasst, die beiden Formgebungseinsätze (2221) einander gegenüberliegend angeordnet sind und sich zwischen den beiden Formgebungseinsätzen (2221) ein Formgebungsbereich befindet, und zumindest ein Teil des runden Wärmerohrs in dem Formgebungsbereich zwischen den beiden Formgebungseinsätzen (2221) angeordnet ist.

18. Formwerkzeug nach Anspruch 17, wobei
die Stütz- und Begrenzungsbaugruppe (23) mindestens ein Stütz- und Begrenzungselement (231) umfasst;
das Stütz- und Begrenzungselement (231) einen Querabschnitt (2311) und mehrere in Abständen angeordnete vertikale Abschnitte (2312) umfasst;
ein Ende jedes vertikalen Abschnitts (2312) mit dem Querabschnitt (2311) verbunden ist, und das andere Ende des vertikalen Abschnitts (2312) in den Spalt zwischen den Formgebungseinsatzgruppen (222) eingeführt ist, so dass sich der vertikale Abschnitt (2312) auf beiden Seiten an den Außenseiten der Formgebungseinsatzgruppen (222) befindet und an der unteren Formplatte (221) anliegt; und
der Querabschnitt (2311) auf den Oberseiten der Formgebungseinsätze (2221) angeordnet ist.

19. Formwerkzeug nach Anspruch 18, wobei das obere Modulelement (21) umfasst:
eine obere Formplatte (211); und
eine Vielzahl von Verriegelungseinsätzen (212), die an der oberen Formplatte (211) angebracht sind, wobei das obere Modul in das untere Modul eingeführt wird und zumindest ein Teil des runden Wärmerohrs, das sich im Formgebungsbereich befindet, während des Einführvorgangs zusammengedrückt wird, um zumindest einen Teil des runden Wärmerohrs, das sich im Formgebungsbereich befindet, zu dem flachen Wärmerohr (12) zusammenzudrücken;
wobei jeder Verriegelungseinsatz (212) ausgerichtet in einen Spalt zwischen den Formgebungseinsatzgruppen (222) eingesetzt wird und sich auf beiden Seiten an den Außenseiten der Formgebungseinsatzgruppen (222) befindet; während des Einführvorgangs zwei Formgebungseinsätze (2221) jeder Formgebungseinsatzgruppe (222) gleichzeitig mittels des Verriegelungseinsatzes (212) zusammengedrückt werden; die beiden Formgebungseinsätze (2221) sich beim Zusammendrücken aufeinander zu bewegen, um zumindest einen Teil des runden Wärmerohrs zusammenzudrücken, so dass zumindest ein Teil des runden Wärmerohrs zu einem flachen Wärmerohr (12) zusammengedrückt wird; und während des Einführvorgangs eine Einführlänge des Verriegelungseinsatzes (212) durch das Stütz- und Begrenzungselement (231) begrenzt wird.

20. Formwerkzeug nach Anspruch 19, wobei eine Dicke des Verriegelungseinsatzes (212) kleiner oder gleich einem Radius des runden Wärmerohrs ist.

21. Formwerkzeug nach Anspruch 18, wobei ein zum Einführen bestimmtes Ende des Verriegelungseinsatzes (212) keilförmig ist.

## Revendications

1. Procédé de fabrication d'un dispositif de dissipation de chaleur tridimensionnel (1), le procédé comprenant :
une étape de fabrication de boîtier thermoconducteur (S1) comprenant la fabrication d'un boîtier thermoconducteur (11) ayant une chambre étanche à l'air ;
une étape de fabrication de dispositif de dissipation de chaleur tridimensionnel préliminaire (S2) comprenant l'installation d'au moins un caloduc rond sur le boîtier thermoconducteur (11) pour former un dispositif de dissipation de chaleur tridimensionnel préliminaire ; et
une étape de fabrication de dispositif de dissipation de chaleur tridimensionnel final (S3) comprenant la fixation du dispositif de dissipation de chaleur tridimensionnel préliminaire au moyen d'un moule de façonnage (2),
**caractérisé par** le façonnage d'un corps tubulaire du caloduc rond en un caloduc plat (12) pour obtenir un dispositif de dissipation de chaleur tridimensionnel final (1).

2. Procédé de fabrication selon la revendication 1, dans lequel le boîtier thermoconducteur (11) comprend un premier boîtier (111) et un second boîtier (112), et l'étape de fabrication de boîtier thermoconducteur (S1) comprend :
la formation d'une première structure capillaire (113) et d'une pluralité de structures de support (114) sur une surface inférieure de l'intérieur du premier boîtier (111) ;
la formation d'une deuxième structure capillaire (115) sur une surface supérieure de l'intérieur du second boîtier (112) ;
la réalisation d'un soudage par diffusion (S13) sur le premier boîtier (111) et le second boîtier (112) ; et
l'installation du second boîtier (112) sur le premier boîtier (111), et la liaison de la première structure capillaire (113) à la deuxième structure capillaire (115) par l'intermédiaire des structures de support (114).

3. Procédé de fabrication selon la revendication 2, dans lequel l'étape de formation de la première structure capillaire (113) et de la pluralité de structures de support (114) sur la surface inférieure de l'intérieur du premier boîtier (111) comprend :
la formation de la première structure capillaire (113) sur la surface inférieure de l'intérieur du premier boîtier (111) par soudage par points de treillis de cuivre ;
le dépôt d'une poudre métallique sur la surface inférieure de l'intérieur du premier boîtier (111), et ensuite la formation d'une colonne de support (1141) de chaque structure de support (114) par frittage ; et
l'agencement d'un anneau de poudre sur la colonne de support (1141) pour former une troisième structure capillaire (1142) de chaque structure de support (114), la troisième structure capillaire (1142) couvrant une surface externe de la colonne de support (1141) ;
dans lequel, lorsque le second boîtier (112) est installé sur le premier boîtier (111), la première structure capillaire (113) est reliée à la deuxième structure capillaire (115) par l'intermédiaire de la troisième structure capillaire (1142).

4. Procédé de fabrication selon la revendication 2, dans lequel l'étape de fabrication de dispositif de dissipation de chaleur tridimensionnel préliminaire (S2) comprend :
la formation d'une quatrième structure capillaire dans le caloduc rond ;
l'insertion d'une extrémité du caloduc rond dans le boîtier thermoconducteur (11) à travers un trou de montage prédéfini (K1) sur le second boîtier (112), de sorte que la quatrième structure capillaire soit reliée à la première structure capillaire (113) ;
la liaison fixe du caloduc rond au second boîtier (112) par un processus de soudage pour former le dispositif de dissipation de chaleur tridimensionnel préliminaire ; et
le remplissage du dispositif de dissipation de chaleur tridimensionnel préliminaire avec un fluide de travail, et ensuite la réalisation d'un processus de scellement du dispositif de dissipation de chaleur tridimensionnel préliminaire.

5. Procédé de fabrication selon l'une des revendications 1 à 4, dans lequel le moule de façonnage (2) comprend un élément de module supérieur (21), un élément de module inférieur (22) et un ensemble de support et de limitation (23), et l'étape de fabrication de dispositif de dissipation de chaleur tridimensionnel final (S3) comprend :
l'installation du dispositif de dissipation de chaleur tridimensionnel préliminaire sur l'élément de module inférieur (22) de sorte qu'au moins une partie du caloduc rond soit située dans une région de façonnage de l'élément de module inférieur (22) ;
l'installation de l'ensemble de support et de limitation (23) sur l'élément de module inférieur (22) pour fixer la région de façonnage ; et
l'insertion de l'élément de module supérieur (21) dans l'élément de module inférieur (22) et la compression d'au moins une partie du caloduc rond située dans la région de façonnage au cours du processus d'insertion pour comprimer au moins une partie du caloduc rond situé dans la région de façonnage en un caloduc plat (12) pour obtenir le dispositif de dissipation de chaleur tridimensionnel final (1).

6. Procédé de fabrication selon la revendication 5, dans lequel l'élément de module inférieur (22) comprend une plaque de moule inférieure (221) et au moins un groupe d'inserts de façonnage (222), les groupes d'inserts de façonnage (222) sont installés sur la plaque de moule inférieure (221) à intervalles, chaque groupe d'inserts de façonnage (222) comprend deux inserts de façonnage (2221), les deux inserts de façonnage (2221) sont agencés à l'opposé l'un de l'autre et il existe une région de façonnage entre les deux inserts de façonnage (2221), et l'étape d'installation du dispositif de dissipation de chaleur tridimensionnel préliminaire sur le module inférieur de sorte qu'au moins une partie du caloduc rond soit située dans la région de façonnage du module inférieur comprend :
l'agencement d'au moins une partie du caloduc rond dans la région de façonnage entre les deux inserts de façonnage (2221).

7. Procédé de fabrication selon la revendication 6, dans lequel l'ensemble de support et de limitation (23) comprend au moins un élément de support et de limitation (231), l'élément de support et de limitation (231) comprend une partie transversale (2311) et une pluralité de parties verticales (2312) agencées à intervalles, une extrémité de chaque partie verticale (2312) est reliée à la partie transversale (2311), et l'étape d'installation de l'ensemble de support et de limitation (23) sur le module inférieur pour fixer la région de façonnage comprend :
l'insertion de l'autre extrémité de la partie verticale (2312) dans un espace entre les groupes d'inserts de façonnage (222) de manière alignée, de sorte que la partie verticale (2312) soit située sur les côtés extérieurs des groupes d'inserts de façonnage (222) de part et d'autre et vienne en butée contre la plaque de moule inférieure (221) ; et
l'agencement de la partie transversale (2311) sur les surfaces supérieures des inserts de façonnage (2221).

8. Procédé de fabrication selon la revendication 7, dans lequel l'élément de module supérieur (21) comprend une plaque de moule supérieure (211) et une pluralité d'inserts de verrouillage (212), les inserts de verrouillage (212) sont installés sur la plaque de moule supérieure (211), et l'étape d'insertion du module supérieur dans l'élément de module inférieur et de compression d'au moins une partie du caloduc rond située dans la région de façonnage au cours du processus d'insertion pour comprimer au moins une partie du caloduc rond située dans la région de façonnage en un caloduc plat (12) pour obtenir le dispositif de dissipation de chaleur tridimensionnel final (1) comprend :
l'insertion de l'insert de verrouillage (212) dans un espace entre les groupes d'inserts de façonnage (222) de manière alignée, de sorte que l'insert de verrouillage (212) soit situé sur les côtés extérieurs des groupes d'inserts de façonnage (222) de part et d'autre ;
la compression de deux inserts de façonnage (2221) de chaque groupe d'inserts de façonnage (222) de manière simultanée au moyen de l'insert de verrouillage (212) au cours du processus d'insertion ; et
la compression d'au moins une partie du caloduc rond par le déplacement l'un vers l'autre des deux inserts de façonnage (2221) lors de la compression, de sorte qu'au moins une partie du caloduc rond soit comprimée en un caloduc plat (12),
dans lequel une longueur d'insertion de l'insert de verrouillage (212) est limitée par l'élément de support et de limitation (231) au cours du processus d'insertion.

9. Procédé de fabrication selon la revendication 8, dans lequel une épaisseur de l'insert de verrouillage (212) est inférieure ou égale à un rayon du caloduc rond.

10. Procédé de fabrication selon la revendication 8 ou 9, dans lequel une extrémité de l'insert de verrouillage (212) pour l'insertion est en forme de coin.

11. Procédé de fabrication selon la revendication 4, dans lequel l'étape de fabrication de dispositif de dissipation de chaleur tridimensionnel préliminaire (S2) comprend en outre :
avant le remplissage du fluide de travail, la réalisation d'un essai d'étanchéité sur le dispositif de dissipation de chaleur tridimensionnel préliminaire.

12. Procédé de fabrication selon la revendication 4, dans lequel le processus de scellement comprend :
la réalisation d'un processus de dégazage du dispositif de dissipation de chaleur tridimensionnel préliminaire après son remplissage avec le fluide de travail ;
le scellage d'un orifice d'injection de fluide de travail du dispositif de dissipation de chaleur tridimensionnel préliminaire par un élément de scellement ; et
le soudage et le scellement de la liaison entre le premier boîtier (111) et le second boîtier (112) par soudage laser.

13. Procédé de fabrication selon la revendication 4, dans lequel l'étape de fabrication de dispositif de dissipation de chaleur tridimensionnel préliminaire (S2) comprend en outre :
le nettoyage du dispositif de dissipation de chaleur tridimensionnel préliminaire après le processus de scellement, et la réalisation d'un essai de vieillissement, d'un essai de performance, d'un traitement de surface et d'un essai d'inspection à l'hélium.

14. Procédé de fabrication selon la revendication 4, comprenant en outre :
une étape d'essai comprenant la réalisation d'un essai de différence de température sur le dispositif de dissipation de chaleur tridimensionnel final (1).

15. Moule de façonnage (2) comprenant :
un corps configuré pour façonner un dispositif de dissipation de chaleur tridimensionnel préliminaire, dans lequel le dispositif de dissipation de chaleur tridimensionnel préliminaire comprend un boîtier thermoconducteur (11) et un caloduc rond installé sur le boîtier thermoconducteur (11), et le dispositif de dissipation de chaleur tridimensionnel préliminaire est fixé par le moule de façonnage (2),
dans lequel le moule permet de façonner un corps tubulaire du caloduc rond du dispositif de dissipation de chaleur tridimensionnel préliminaire en un caloduc plat (12) pour obtenir un dispositif de dissipation de chaleur tridimensionnel final (1).

16. Moule de façonnage selon la revendication 15, dans lequel le moule de façonnage (2) comprend :
un élément de module inférieur (22) dudit corps, le dispositif de dissipation de chaleur tridimensionnel préliminaire étant installé sur ledit élément de module inférieur (22) de sorte qu'au moins une partie du caloduc rond soit située dans une région de façonnage de l'élément de module inférieur (22) ;
un ensemble de support et de limitation (23) installé sur l'élément de module inférieur (22) pour fixer la région de façonnage ; et
un élément de module supérieur (21) pour l'insertion dans l'élément de module inférieur (22) et la compression d'au moins une partie du caloduc rond située dans la région de façonnage au cours du processus d'insertion pour comprimer au moins une partie du caloduc rond située dans la région de façonnage en un caloduc plat (12) pour obtenir le dispositif de dissipation de chaleur tridimensionnel final (1).

17. Moule de façonnage selon la revendication 16, dans lequel l'élément de module inférieur (22) comprend :
une plaque de moule inférieure (221) ; et
au moins un groupe d'inserts de façonnage (222), dans lequel les groupes d'inserts de façonnage (222) sont installés sur la plaque de moule inférieure (221) à intervalles, chaque groupe d'inserts de façonnage (222) comprend deux inserts de façonnage (2221), les deux inserts de façonnage (2221) sont agencés à l'opposé l'un de l'autre, et il existe une région de façonnage entre les deux inserts de façonnage (2221), et au moins une partie du caloduc rond est agencée dans la région de façonnage entre les deux inserts de façonnage (2221).

18. Moule de façonnage selon la revendication 17, dans lequel
l'ensemble de support et de limitation (23) comprend au moins un élément de support et de limitation (231) ;
l'élément de support et de limitation (231) comprend une partie transversale (2311) et une pluralité de parties verticales (2312) agencées à intervalles ;
une extrémité de chaque partie verticale (2312) est reliée à la partie transversale (2311), et l'autre extrémité de la partie verticale (2312) est insérée dans l'espace entre les groupes d'inserts de façonnage (222) de sorte que la partie verticale (2312) soit située sur les côtés extérieurs des groupes d'inserts de façonnage (222) de part et d'autre et vienne en butée contre la plaque de moule inférieure (221) ; et
la partie transversale (2311) est agencée sur les surfaces supérieures des inserts de façonnage (2221).

19. Moule de façonnage selon la revendication 18, dans lequel l'élément de module supérieur (21) comprend :
une plaque de moule supérieure (211) ; et
une pluralité d'inserts de verrouillage (212) installés sur la plaque de moule supérieure (211), dans lequel le module supérieur est inséré dans le module inférieur, et au moins une partie du caloduc rond située dans la région de façonnage est comprimée au cours du processus d'insertion pour comprimer au moins une partie du caloduc rond située dans la région de façonnage en un caloduc plat (12) ;
dans lequel chaque insert de verrouillage (212) est inséré dans un espace entre les groupes d'inserts de façonnage (222) de manière alignée, et est situé sur les côtés extérieurs des groupes d'inserts de façonnage (222) de part et d'autre ; au cours du processus d'insertion, deux inserts de façonnage (2221) de chaque groupe d'inserts de façonnage (222) sont comprimés simultanément au moyen de l'insert de verrouillage (212) ; les deux inserts de façonnage (2221) se déplacent l'un vers l'autre lors de la compression pour comprimer au moins une partie du caloduc rond, de sorte qu'au moins une partie du caloduc rond soit comprimée en un caloduc plat (12) ; et, au cours du processus d'insertion, une longueur d'insertion de l'insert de verrouillage (212) est limitée par l'élément de support et de limitation (231).

20. Moule de façonnage selon la revendication 19, dans lequel une épaisseur de l'insert de verrouillage (212) est inférieure ou égale à un rayon du caloduc rond.

21. Moule de façonnage selon la revendication 18, dans lequel une extrémité de l'insert de verrouillage (212) pour l'insertion est en forme de coin.
